# EUROPÄISCHE PATENTANMELDUNG

(11) **EP 1 132 663 A2**
(43) Veröffentlichungstag der Anmeldung: **12.09.2001**
(21) Anmeldenummer: 01104001.1
(22) Anmeldetag: 20.02.2001
(51) Int. Cl.: F16J 9/26

(54) **Kolbenring mit Verschleissschutzschicht sowie Verschleissschutzschicht für einen Kolbenring**

(30) Priorität: 11.03.2000 DE 10011917
(71) Anmelder: Federal-Mogul Burscheid GmbH, 51399 Burscheid (DE)
(72) Erfinder: Buran, Ulrich, Dipl.-Ing., 51399 Burscheid (DE); Münchow, Frank, 42929 Wermelskirchen (DE); Fischer, Manfred, Dr., 41799 Leichlingen (DE)

(57) **Zusammenfassung**

Kolbenring mit einer, zumindest im Bereich der Lauffläche vorgesehenen Verschleißschutzschicht, die im wesentlichen aus den Elementen Titan, Bor und Stickstoff zusammengesetzt und nach dem PVD- oder CVD-Verfahren aufgebracht ist, wobei die Schichtdicke max. 100 µm, insbesondere 5 bis 50 µm, beträgt.

## Beschreibung

Kolbenring mit Verschleißschutzschicht sowie Verschleißschutzschicht für einen Kolbenring

Die Erfindung betrifft einen Kolbenring für Brennkraftmaschinen mit einer, zumindest im Bereich der Lauffläche vorgesehenen Verschleißschutzschicht, die nach den PVD-oder CVD-Verfahren aufgebracht ist.

Zur Verlängerung der Lebensdauer von Brennkraftmaschinen ist es allgemein bekannt, die Laufpartner Kolbenring/Zylinderlauffläche mit besonders verschleißfesten Schichten zu versehen.

Es ist bekannt, Kolbenringlaufflächen mit Verschleißschutzschichten zu versehen, die nach dem Plasmaspritzverfahren, nach galvanischen Verfahren, durch Nitrieren oder Verfahren der Dünnschichttechnologie aufgebracht sind.

Es ist bekannt, Dampfabscheideprozesse einzusetzen, mit denen dann die Laufflächen oder die gesamte äußere Umfangsfläche der Kolbenringe mit verschleißfesten Schichten versehen werden. Allgemein bekannt sind hier Verfahren der physikalischen bzw. chemischen Dampfabscheidung (PVD-/CVD-Verfahren). Zu den PVD-Verfahren gehören neben der Dampfabscheidung auch die Kathodenzerstäubung bzw. Vakuumbedampfung sowie die Ionenplattierung.

Der DE-A 43 25 520 ist unter anderem ein Kolbenring zu entnehmen, der laufflächenseitig eine Beschichtung aus einem reaktionsträgen, antiadhäsiven Metall (vorzugsweise Niob oder Zirkon) aufweist. Die Beschichtung soll im PVD-Arc-Verfahren aufgebracht werden.

Durch die US-A 5,449,547 ist ein hartes Beschichtungsmaterial sowie ein damit versehener Gleitkörper, wie ein Kolbenring, bekannt geworden. Die Hartschicht, für den aus Stahl, Gußeisen, Titan oder einer Titanlegierung bestehenden Gleitkörper beinhaltet entweder 3 bis 20 Gew.-% Sauerstoff oder 2 bis 11 Gew.-% Kohlenstoff, wobei der Sauerstoff bzw. der Kohlenstoff in einer CrN-Kristallstruktur enthalten ist und wobei Härten HV im Bereich zwischen 1600 und 2200 erreicht werden. Die Hartschicht wird vorzugsweise durch Ionenplattierung auf den Gleitkörper aufgebracht. Da beim PVD-Prozeß Sauerstoffgas an der Oberfläche des Kolbenringwerkstoffes oxidiert, ist die Gefahr gegeben, daß die verschleißfeste Schicht auf der Kolbenringoberfläche nicht optimal haftet und so abblättern kann.

Um dieses Problem zu lösen, ist es durch die US-A 5,582,414 bekannt, auf der Kolbenringoberfläche zunächst eine Zwischenschicht abzuscheiden, auf welche dann die Hartschicht durch Ionenplattierung abgeschieden wird. Die Zwischenschicht setzt sich zusammen aus wenigstens eines der Elemente oder Verbindungen aus der nachstehenden Gruppe Cr₂N, CrN, Cr bzw. Cr₂N und CrN. Die Hartschicht soll 3 bis 20 Gew.-% Sauerstoff in einer CrN-Kristallstruktur enthalten und dann eine Härte HV zwischen 1600 und 2200 aufweisen.

Durch die US-A 5,820,131 ist ein Kolbenring mit einer Verschleißschutzschicht bekannt geworden, die auf Basis von Cr2N bzw. einer Mischung aus Cr₂N und Cr durch Ionenplattierung auf der Lauffläche des Kolbenringes abgeschieden wird. Der Stickstoffgehalt dieser Verschleißschutzschicht soll zwischen 11 und 17 Gew.-% liegen, wobei Härten HV dieser Schicht zwischen 1300 und 2000 erreicht werden sollen. Nachteilig ist hier festzustellen, daß sich je nach Stickstoffanteil das Verschleißverhalten der Schicht ändert. Bei einem Anteil von 11 Gew.-% N ist das Verschleißverhalten gegenüber einem Anteil von 17 Gew.-% N schlechter, wobei jedoch das Verhalten des Kolbenringes im Hinblick auf den Ölverbrauch wiederum verbessert wird.

Der JP-A 62058050 ist ein Kolbenring zu entnehmen, der laufflächenseitig eine etwa 5 µm dicke Verschleißschutzschicht aus TiN aufweist. Zwischen der Verschleißschutzschicht und der äußeren Kolbenring-Umfangsfläche befindet sich eine superharte Zwischenschicht aus Ti (C, N), TiC, SiC oder Al₂O₃, die eine Dicke von etwa 15 µm aufweist. Die Beschichtung der Kolbenring-Lauffläche erfolgt durch das Plasma-CVD-Verfahren bzw. durch Ionenplattierung.

Die nach den bekannten PVD-/CVD-Verfahren abgeschiedenen, zitierten Verschleißschutzschichten verfügen zwar über gute Festigkeits- und Brandspureigenschaften, wobei jedoch die Verschleißfestigkeit dieser Schichten nicht ausreichend hoch ist. Da sich diese Schichten auch nur in begrenzten Dicken ausführen lassen, werden die Forderungen an die Lebensdauer nicht erreicht, so daß sie, insbesondere für Motoren mit hoher Leistung, hohen Zylinderdrücken, Direkteinspritzung, Abgasrückführung und anderen Konstruktionsmerkmalen neuerer Motorentwicklungen, aber auch die Minimierung des Ölverbrauches, nicht optimal anwendbar sind.

Der Erfindung liegt die Aufgabe zugrunde, einen Kolbenring mit einer solchen Verschleißschutzschicht zu versehen, die im Hinblick auf die Brandspursicherheit optimiert ist, wobei gleichzeitig die tribologischen Eigenschaften verbessert werden. Darüber hinaus liegt der Erfindung auch die Aufgabe zugrunde, eine Verschleißschutzschicht für einen Kolbenring zu konzipieren, die zwar auf einer bekannten Abscheidungstechnologie beruht, jedoch gegenüber bisher bekannten Verschleißschutzschichten, insbesondere hinsichtlich der Standzeit, optimiert ist.

Diese Aufgabe wird gelöst durch einen Kolbenring, gemäß der kennzeichnenden Merkmale des Patentanspruchs 1 und 6.

Vorteilhafte Weiterbildungen des erfindungsgemäßen Kolbenringes sind den zugehörigen Unteransprüchen zu entnehmen.

Die erfindungsgemäße Verschleißschutzschicht besitzt eine hohe innere Festigkeit und läßt sich bei entsprechender Vorbehandlung mit ausgezeichneter Haftung auf die Kolbenringbasiswerkstoffe, wie Stahl und Gußeisen aufbringen. Sie verfügt darüber hinaus über eine hohe Brandspursicherheit sowie ein sehr gutes Eigenverschleißverhalten und greift den Gegenpartner, nämlich die Zylinderlaufbuchse, nicht an. Die Verschleißschutzschicht ist korrosionsfest gegenüber den im Verbrennungsraum auftretenden Medien und besitzt eine hohe Wärmeleitfähigkeit, um den Wärmetransport vom Verbrennungsraum über Kolben und Kolbenringe an die Zylinderlauffläche gut ausführen zu können.

Titan, Bor und Stickstoff sind hierbei in einem aufeinander abgestimmten Verhältnis in der Schicht einzubinden, so daß die vorab genannten Vorteile erreicht werden.

Für ein optimiertes Laufverhalten hat sich eine Schicht folgender Zusammensetzung bewährt: Ti-Gehalt zwischen 50 und 60 Atom %, Stickstoffgehalt zwischen 20 und 50 Atom % sowie einem Borgehalt zwischen 1 und 30 Atom %.

Die erfindungsgemäße Schichtkombination aus Ti, B, N vermindert gegenüber anderen, durch bekannte PVD- bzw. CVD-Verfahren, abgeschiedenen Schichten für Kolbenringe die Eigenspannung in der Schicht, so daß Schichtdicken bis zu 100 µm erzeugt werden können. Bevorzugte Schichtdicken bei der Anwendung auf Kolbenringen, insbesondere laufflächenseitig, sind 5 bis 50 µm.

Der Erfindungsgegenstand ist anhand eines Ausführungsbeispiels in der Zeichnung dargestellt und wird wie folgt beschrieben. Es zeigen:
- Figur 1: Kompressionskolbenring mit laufflächenseitiger Verschleißschutzschicht;
- Figur 2: Ölabstreifkolbenring mit Verschleißschutzschicht.

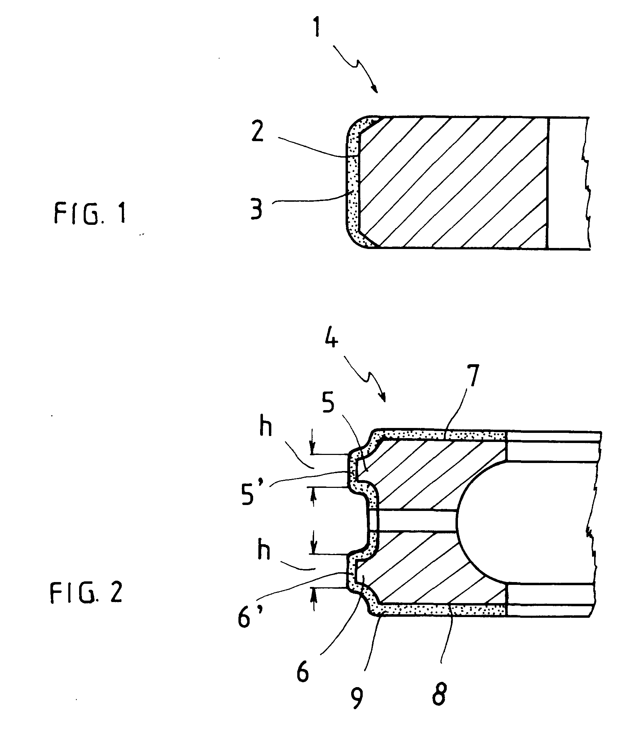

Figur 1 zeigt einen aus Gußeisen bestehenden Kompressionskolbenring 1, der im Bereich seiner Lauffläche 2 mit einer Verschleißschutzschicht 3 versehen ist. Die Verschleißschutzschicht besteht aus den Elementen Titan, Stickstoff und Bor mit folgender Zusammensetzung: Ti-Gehalt zwischen 50 und 60 Atom %, Stickstoffgehalt zwischen 20 und 50 Atom % sowie einem Borgehalt zwischen 1 und 30 Atom %. Das Aufbringen der Verschleißschutzschicht 3 kann einerseits mit PVD-Verfahren (Physikalische Abscheidung aus der Dampfphase) und andererseits mit CVD-Verfahren (Chemische Abscheidung aus der Dampfphase) auf der Lauffläche 2 des Kompressionskolbenringes 1 mit einer Schichtdicke von 50 µm erfolgen.

Der Vorteil der PVD-Verfahren gegenüber den CVD-Verfahren besteht darin, daß die Beschichtungstemperaturen deutlich niedriger liegen. Die Auswahl des Abscheidungsverfahrens ist jedoch vom Anwendungsfall abhängig und wird vom zuständigen Fachmann ausgewählt. Die Verschleißschutzschicht 3 soll in diesem Beispiel nach den PVD-Verfahren ausschließlich auf der Lauffläche 2 des Kompressionskolbenringes 1 abgeschieden sein.

Figur 2 zeigt einen aus Stahlband gebogenen Ölabstreifkolbenring 4, der zwei Laufstege 5,6 aufweist, die definierte Laufsteghöhen h haben. In diesem Beispiel sind sämtliche dem Verschleiß ausgesetzten Bereiche (Laufflächen 5', 6' sowie die Stirnflächen 7,8) mit einer Verschleißschutzschicht 9 folgender chemischer Zusammensetzung versehen:

Ti-Gehalt zwischen 50 und 60 Atom %, Stickstoffgehalt zwischen 20 und 50 Atom % sowie einem Borgehalt zwischen 1 und 30 Atom %.

Auch hier wurde die Verschleißschutzschicht 9 nach dem bekannten PVD-Verfahren auf den genannten Flächen 5', 6', 7, 8 abgeschieden und soll eine Schichtdicke von 40 µm beinhalten.

Derartig abgeschiedene Ti-B-N-Verschleißschutzschichten 3,9 weisen gegenüber dem bekannten Stand der Technik eine hohe innere Festigkeit auf und lassen sich bei entsprechender Vorbehandlung des Kolbenringes 1,4 mit ausgezeichneter Haftung auf Kolbenringbasiswerkstoffe, wie Stahl oder Gußeisen, aufbringen. Die Verschleißschutzschichten 3,9 verfügen über eine hohe Brandspursicherheit, optimale Eigenverschleißeigenschaften und sind korrosionsfest gegenüber den, im Verbrennungsraum auftretenden Medien.

## Patentansprüche

1. Kolbenring für Brennkraftmaschinen mit einer, zumindest im Bereich der Lauffläche (2,5',6') vorgesehenen Verschleißschutzschicht (3,9) die nach den PVD- oder CVD-Verfahren aufgebracht ist, **dadurch gekennzeichnet, daß** die Verschleißschutzschicht (3,9) im wesentlichen aus den Elementen Titan, Bor und Stickstoff zusammengesetzt ist, wobei die Schichtdicke max. 100 µm, insbesondere 5 bis 50 µm, beträgt wobei der Ti-Gehalt zwischen 50 und 60 Atom %, der Stickstoffgehalt zwischen 20 und 50 Atom % und der Borgehalt zwischen 1 und 30 Atom % liegt.

2. Kolbenring nach Anspruch 1, **dadurch gekennzeichnet, daß** die Verschleißschutzschicht (3,9) eine Härte HV von 1000 bis 2200 aufweist.

3. Kolbenring nach einem der Ansprüche 1 und 2, **dadurch gekennzeichnet, daß** die Verschleißschutzschicht (3, 9) mit einer Dicke von 5 bis 20 µm auf die Lauffläche (2,5',6') des Kolbenringes (1,4) aufgebracht ist.

4. Kolbenring nach einem der Ansprüche 1 bis 3, **dadurch gekennzeichnet, daß** die Lauffläche des Kolbenringes eine gehärtete Oberfläche aufweist, auf die die Verschleißschutzschicht (3,9) aufgebracht ist.

5. Kolbenring nach Anspruch 4, **dadurch gekennzeichnet, daß** die Oberfläche nitriert, verchromt oder durch thermisches Spritzen gehärtet ist.

6. Verschleißschutzschicht für Kolbenringe (1,4) mit der allgemeinen Formel Ti_B_ N, mit einem Ti-Gehalt zwischen 50 und 60 Atom %, Stickstoffgehalt zwischen 20 und 50 Atom % sowie einem Borgehalt zwischen 1 und 30 Atom %.

7. Verschleißschutzschicht für Kolbenringe (1,4) nach Anspruch 6, **dadurch gekennzeichnet, daß** die Verschleißschutzschichtschicht (3,9) mit einer Schichtdicke von bis zu 100 µm, insbesondere 5 bis 50 µm, nach dem PVD- oder CVD-Verfahren, zumindest auf die Lauffläche (2,5',6') des Kolbenringes (1,4) aufgebracht ist.

8. Verschleißschutzschicht nach Anspruch 6, **dadurch gekennzeichnet, daß** die Verschleißschutzschichtschicht (3,9) auf allen dem mittel- oder unmittelbaren Verschleiß ausgesetzten Flächenbereichen (2,5',6',7,8) des Kolbenringes (1,4) aufgebracht ist.

9. Verschleißschutzschicht nach einem der Ansprüche 7 bis 8, **dadurch gekennzeichnet, daß** die Verschleißschutzschicht (3,9) eine Härte HV von 2000 bis 3000 aufweist.
